(19) Europäisches Patentamt

European Patent Office

Office européen des brevets

(11) EP 0 967 664 B1

(12) **EUROPEAN PATENT SPECIFICATION**

(45) Date of publication and mention
of the grant of the patent:
**13.09.2006 Bulletin 2006/37**

(51) Int Cl.:
*H01L 33/00* (2006.01)   *H01L 21/205* (2006.01)

(21) Application number: **99110229.4**

(22) Date of filing: **26.05.1999**

(54) **Gallium nitride single crystal substrate and method of producing the same**

Einkristall Galliumnitridsubstrat und Verfahren zu dessen Herstellung

Substrat monocristallin de nitrure de gallium et procédé de fabrication

(84) Designated Contracting States:
**DE FR GB**

(30) Priority: **28.05.1998 JP 14771698**

(43) Date of publication of application:
**29.12.1999 Bulletin 1999/52**

(60) Divisional application:
**06006946.5 / 1 672 708**
**06015516.5**

(73) Proprietor: **Sumitomo Electric Industries, Ltd.
Osaka (JP)**

(72) Inventors:
 • **Motoki, Kensaku**
  **1-1. Koyakita 1-chome,
  Itami-shi,
  Hyogo (JP)**
 • **Okahisa, Takuji**
  **1-1. Koyakita 1-chome,
  Itami-shi,
  Hyogo (JP)**
 • **Matsumoto, Naoki**
  **1-1. Koyakita 1-chome,
  Itami-shi,
  Hyogo (JP)**
 • **Matsushima, Masato**
  **1-1. Koyakita 1-chome,
  Itami-shi,
  Hyogo (JP)**

(74) Representative: **Grünecker, Kinkeldey,
Stockmair & Schwanhäusser
Anwaltssozietät
Maximilianstrasse 58
80538 München (DE)**

(56) References cited:
**EP-A- 0 720 240**    **EP-A- 0 810 674**
**WO-A-99/23693**    **WO-A1-99/23693**
**US-B1- 6 413 627**    **US-B1- 6 468 347**
**US-B2- 6 468 882**

 • **CHUNG B-C AND GERSHENZON M: "The influence of oxygen on the electrical and optical properties of GaN crystals grown by metalorganic vapor phase epitaxy" JOURNAL OF APPLIED PHYSICS, vol. 72, no. 2, 15 July 1992 (1992-07-15), pages 651-659, XP002114314**
 • **TSUCHIYA H ET AL: "HOMOEPITAXIAL GROWTH OF CUBIC GAN BY HYDRIDE VAPOUR PHASE EPITAXY ON CUBIC GAN/GAS SUBSTRATES PREPARED WITH GAS SOURCE MOLECULAR BEAM EPITAXY" JAPANESE JOURNAL OF APPLIED PHYSICS, vol. 33, no. 4A, PART 01, 1 April 1994 (1994-04-01), pages 1747-1752, XP000487621 ISSN: 0021-4922**
 • **PATENT ABSTRACTS OF JAPAN vol. 098, no. 012, 31 October 1998 (1998-10-31) & JP 10 200161 A (NEC CORP), 31 July 1998 (1998-07-31)**
 • **NAOI Y ET AL: "Characterization of bulk GaN grown by sublimation technique" JOURNAL OF CRYSTAL GROWTH, vol. 189-190, 15 June 1998 (1998-06-15), page 163-166 XP004148496 ISSN: 0022-0248**
 • **SATO H ET AL: "TRANSPARENT AND CONDUCTIVE GAN THIN FILMS PREPARED BY AN ELECTRON CYCLOTRON RESONANCE PLASMA METALORGANIC CHEMICAL VAPOR DEPOSITION METHOD" JOURNAL OF VACUUM SCIENCE AND TECHNOLOGY: PART A, vol. 11, no. 4, PART 01, 1 July 1993 (1993-07-01), pages 1422-1425, XP000403745 ISSN: 0734-2101**

- **HIRAMATSU K ET AL: "Selective area growth and epitaxial lateral overgrowth of GaN by metalorganic vapor phase epitaxy and hydride vapor phase epitaxy" MATERIALS SCIENCE AND ENGINEERING B, vol. 59, no. 1-3, 6 May 1999 (1999-05-06), page 104-111 XP004173214 ISSN: 0921-5107**
- **USUI A.: 'Thick Layer Growth of GaN by Hydride Vapor Phase Epitaxy' COLLECTION OF THESES OF ELECTRONIC INFORMATION COMMUNICATION SOCIETY vol. J81-C-II, no. 1, January 1998, pages 58 - 64**

- **J. APPL. PHYS, vol. 75, no. 3, 1 February 1994 (1994-02-01), pages 1405-1409,**
- **PHYS. REV. LETT., vol. 78, no. 20, 19 May 1997 (1997-05-19), pages 3923-3926,**

Remarks:
   The file contains technical information submitted after the application was filed and not included in this specification

**Description**

This invention relates to a method of making a gallium nitride (GaN) single crystal substrate for producing a light emitting diode (LED) and a laser diode (LD) or a field effect transistor (FET) making use of the group III - V nitride compound semiconductors, in particular, to a method of making a n-type GaN substrate. In this description, the impurity which determines the conduction type of a semiconductor is called a dopant for discerning the conduction-type determined impurity from the other impurities.

Among the periodic-table group III-V compound semiconductors, large substrate crystals can be produced only for gallium arsenide (GaAs), indium phosphide (InP) and Gallium phosphide (GaP). These semiconductors allow us to produce large-scaled bulk crystals by the Bridgman method or the Czochralski method. Substrate wafers are prepared by slicing the large and long single crystal ingots of GaAs, InP or GaP. There is not a matured technology for growing a large single crystal of gallium nitride (GaN) yet.

Gallium nitride (GaN) is important as a material of blue-light emitting devices due to the wide band gap. Since any GaN wafer has never existed yet, foreign materials are employed as a substrate of light emitting devices (LDs or LEDs). Blue light LEDs or LDs can be made by heteroepitaxially depositing GaN films or other nitride films on a pertinent foreign material. The lattice constants and the lattice structures are different between the nitride film materials and the substrate material. The different lattice constants and the different lattice structures produce a plenty of defects in the gallium nitride (GaN) film. Despite the large density of defects, the GaN LED can emit strong blue light. The lifetime of the GaN LED is long enough. The ability of making strong blue light in spite of many defects is a strange and miraculous property of GaN. The high resistance against the defects is quite different from other III-V compound semiconductors , e.g., gallium arsenide (GaAs) or indium phosphide (InP) which has ardently required a thoroughgoing decrease of defect density.

Here, the nitride semiconductor means a restricted concept of a III-V semiconductor including AlN, InN, GaN and a mixture of AlN, InN and GaN at arbitrary rates. The main part is GaN in any cases. The active layer including In, Ga and N at a pertinent rate is written as GaInN in brief.

A prior LED of the nitride semiconductor employs a sapphire single crystal as a substrate. The LED based on the nitride semiconductor is made by piling epitaxially GaN films or GaN-like films upon the sapphire substrate by the MOCVD (metallorganic chemical vapor deposition) method. The MOCVD method selects a gallium-including metallorganic compound and ammonia ($NH_3$) as starting materials and directly makes the Ga-including metallorganic compound react with ammonia ($NH_3$) for producing a GaN film. Silane gas ($SiH_4$) should be added to the material gas for making an n-type GaN film. Si plays the role of the n-type dopant in the GaN film.

A GaN substrate should be the best substrate for GaN films from the stand point of the common lattice constant and the common lattice structure. But a large GaN substrate cannot be produced at present yet. The impossibility of making a GaN substrate forces the manufacturers to adopt a sapphire substrate for making blue GaInN LEDs. Sapphire has some advantages as a substrate. Sapphire is a stable and rigid material. Sapphire has high chemical resistance and high heat-resistance. Although the discrepancy of lattice constants between sapphire and GaN is large, the sapphire substrate allows the manufacturers to produce GaN films of an excellent property. In addition, sapphire is an inexpensive material. Sapphire wafers are sold on the market. Easy access is also an advantage of sapphire. For these reasons, sapphire is exclusively used as a substrate for GaN-like devices at present on an industrial scale. Other material substrates have been sometimes proposed on a laboratory scale. However, the substrates of GaN light emitting devices on the market are sapphire without exception.

Sapphire has some weak points. One of the drawbacks is the lack of cleavage planes. Another is extreme rigidity. A further weak point is electrical insulation. Non-cleavage, rigidity and insulation are drawbacks of sapphire as a substrate material. In general, conventional laser diodes have exploited natural, parallel cleavage planes as mirrors of a resonator. In fact, GaAs lasers and InP lasers make the best use of the natural cleavage planes as a resonator. Natural cleavage enables manufacturer to cut a single crystal easily and neatly for making mirror planes. The cleavage planes enjoy high reflection. Since sapphire has no cleavage plane, the sapphire wafer is cut by a mechanical cutter for separating a processed sapphire wafer into LED chips. It is difficult to cut the sapphire wafer due to the rigidity and the non-cleavage. The as-cut planes are still rough. The cut planes must be further polished for raising a reflection rate. Parallel polished planes are assigned as resonator mirrors of an LD. The mechanical polished surface is inferior to the natural cleavage planes in the reflection property. The reflection rate of the forcibly polished surface is still lower than that of the natural cleavage plane. This is an extra drawback of making a laser diode of GaInN.

An LED (light emitting diode) has no resonator. The LED is free from the difficulty of the low reflection. However, the lack of cleavage casts a shadow also on the LED for another reason. The non-cleavage raises the difficulty of dicing the sapphire wafer into chips. The difficulty of dicing raises the cost of producing GaInN LEDs. If the sapphire wafer had cleavage planes, the wafer would be far easily diced into plenty of chips. The greatest drawback of the sapphire substrate is the lack of cleavage in any cases.

Someone studies a GaInN LED utilizing silicon carbide (SiC) as a substrate instead of sapphire ($Al_2O_3$) for

overcoming the difficulty of the non-cleavage. SiC has a lattice constant similar to GaN and high heat resistance. SiC allows GaN to grow epitaxially thereon. SiC has cleavage planes which would ensure facile dicing and serve resonant mirror planes in an LD. SiC is superior to sapphire in cleavage. SiC is, however, a highly expensive material. There is no matured technology of producing SiC bulk single crystals on a large scale yet. The difficulty of supply would raise the cost of GaInN LEDs, if GaInN films were to be piled upon an SiC substrate. The present technology cannot produce SiC-based GaInN LEDs on a large scale at a lower cost than sapphire-based GaInN LEDs. There is poor probability for SiC substrates in overcoming sapphire substrates. SiC is not a promising material as a substrate of GaN-like semiconductors.

The sapphire substrate induces a problem of a big defect density in the epitaxial GaN-like films due to the difference of the lattice constant between GaN and sapphire ($Al_2O_3$). In fact, dislocations of a high density (about $10^9$ $cm^{-2}$) are included in the GaN epitaxial films of the GaN devices (LEDs) on sale. In the case of GaAs, the GaAs bulk single crystal made by the Czochralski method had contained about $10^4$ $cm^{-2}$ defects and the GaAs single epitaxial film had included less defect density than the GaAs bulk single crystal. But, $10^4$ $cm^{-2}$ was too high defect density to make a practical GaAs device. Intensive efforts had been made to reduce the defects in GaAs crystals. Unlike GaAs, the GaN device on the sapphire substrate acts as a good LED in spite of the surprisingly high defect density of $10^9$ $cm^{-2}$ . GaN on sapphire is a miraculous, strange extraordinary material. The enormous density of defects does not hinder GaInN LEDs from emitting beams. In the case of a GaInN laser, it is supposed that the high density of defects in GaN or GaInN films may restrict the lifetime of the laser, because of large current density and big heat generation.

The reason why GaN epitaxial layers in the GaInN blue LED contain about $10^9$ $cm^{-2}$ dislocations is that the substrate is sapphire. The current GaInN LED includes the heteroepitaxy of GaN-like films on a sapphire substrate. The differences of the lattice constants and the crystal structures bring about enormous dislocations and other defects. The high density defects affect little GaN-like LEDs.

But GaInN LDs are plagued by the highly populated defects due to large current density. Further improvements are desired for the GaInN LDs. One way is to adhere to the sapphire and to make a lower density GaN crystal on the sapphire substrate. It has been confirmed that the lifetime of the LD can be prolonged by building the GaInN LD structure upon a low-defect GaN layer epitaxially piled on a sapphire substrate by an ELO (Epitaxial Lateral Overgrowth) method instead of directly on a sapphire substrate. The intervening GaN layer improves the property of the LD.

The ELO is a new technique of covering a sapphire wafer with a mask, making apertures on the mask and piling GaN on the sapphire wafer within the apertures till the GaN covers the mask. It was proposed by ① Electron, Information and Communication Society C-II, vol. J81-C-II, p58-64.

① alleged that the defect density in the GaN-like films on the ELO GaN layer was smaller than the prior GaN-like films on the sapphire wafer. The epitaxial lateral overgrowth (ELO) is explained more in detail. A single crystal sapphire is coated with a mask which has a function of inhibiting GaN from growing on the mask. Parallel stripe apertures are made on the mask by etching in a direction of a crystal axis of the sapphire. The direction of the stripes is dented by "y-axis". The longitudinal sides of a stripe aperture are simply designated by x=k $\triangle$, x=(k+ ε) $\triangle$, where k is an integer, $\triangle$ is a spatial period in the x-direction and εΔ is a aperture width. The direction of the stripe (y-axis) is either [11-2] direction or [1-10] direction of the sapphire crystal. Since the mask has the function of suppressing the growth of GaN, GaN does not pile upon the mask but piles only on the revealed undercoat sapphire. Initially, many small isolated GaN nuclei appear on the undercoat sapphire. The sapphire undercoat determines the crystallographical directions of the nuclei. GaN grains grow around the GaN nuclei. GaN films are soon formed from the GaN grains in the elongated parallel apertures of the mask. The GaN films fill the apertures of the stripe mask. When the top of the GaN films attain the top of the stripe mask, the GaN films begin to grow also in the horizontal directions upon the mask.

As the isolated GaN films grow further on the mask surface, neighboring striped GaN films come in contact with each other on the mask. The individual GaN films have a common orientation determined by the undercoat GaAs single crystal substrate. The unified GaN films fortunately form a single crystal. The joint lines are nearly straight middle lines between the neighboring stripes. Since the joining GaN films have grown independently in the free spaces on the mask apertures, the films are free from inner stress. Little stress invites little amount of defects. The GaN films are low defect crystals. When neighboring films meet on the middle joint lines, stress first appears. But the stress is so weak that defects do not increase. As the number of the GaN layer increases, the defects decrease. Thus, the GaN film on the stripe-masked sapphire has weaker strain than prior GaN film on sapphire. The stripe-mask decreases defects in the GaN film on the non-masked sapphire.

① alleged that the ELO could reduce the defects in the GaN film on a sapphire substrate by the function of the striped mask. But it is impossible to eliminate the sapphire substrate, since sapphire has high resistance against chemical reactions and high stability against heat. Sapphire is very hard. There is no means of eliminating only the sapphire substrate having high rigidity, high heat and chemical resistance. It is also difficult to polish the sapphire substrate due to big distortion of the GaN/sapphire wafer. Since it is impossible to remove the sapphire substrate, devices should be made on the GaN film adhering to the sapphire wafer. The difficulty of dicing appears on the improved ELO GaN film on sapphire like conventional GaInN LEDs on sapphire. The GaN/sapphire wafer distorts due to the difference of thermal expansion coefficients. The distortion disturbs exact patterning by the photolithography, because the photoresist patterns deform. The distortion impedes the wafer process for making devices on the GaN films. The ELO GaN film on sapphire cannot solve these problems at all. As long as the sapphire substrate accompanies the GaN film, the problems of the non-cleavage, the difficulty of dicing and the distortion cannot be overcome. The heterostructure of GaN/sapphire should be changed.

The optimum substrate for GaN devices would, of course, be a GaN bulk crystal. A GaN crystal has cleavage planes unlike sapphire. If a GaN film were to be piled epitaxially upon a GaN single crystal substrate, the defects in the GaN film would be reduced. The cleavage would facilitate to dice a wafer into chips. The cleavage planes would give high reflection mirrors to a resonator of an LD. The GaN/GaN homo-structure would suppress distortion. The GaN substrate would be superior to the sapphire substrate both in mechanical properties and in physical properties.

The Czochralski method and the Bridgman method can make a large bulk single crystal in general. They grow single crystals from a material melt by solidifying gradually the melt and maintaining the equilibrium between liquid phase and solid phase. Unfortunately, neither Czochralski method nor Bridgman method can produce GaN bulk single crystals owing to the lack of a GaN melt. The vapor pressure at a high temperature is too large to make a GaN melt. When the GaN solid is heated, the GaN does not melt but does sublime. It is impossible to prepare a GaN melt at present. It is said that both high temperature and ultrahigh pressure would make a GaN melt in a ultrahigh pressure vessel. Even if a GaN melt were to be prepared, the ultrahigh pressure method would produce a very small GaN grain crystal which is of no use as a substrate. A bulk GaN crystal cannot be produced from a melt in the equilibrium with the solid phase and the liquid phase.

The Inventors have still believed in the special importance of preparing a GaN substrate despite these apparent difficulties. The solid belief has guided the Inventors to a new method of producing a GaN substrate by growing GaN on a GaAs substrate by an improved ELO method and etching away the GaAs substrate and the mask. The feature is the possibility of making a wide, freestanding bulk GaN single crystal. The lateral GaN growth method includes the steps of preparing a GaAs single crystal substrate wafer, coating a mask on the GaAs wafer, perforating the mask in dotted windows or in striped windows for revealing the undercoat GaAs, depositing a GaN buffer film through the windows of the mask upon the revealed GaAs, piling a GaN epitaxial film on the buffer film and on the mask, etching away the GaAs wafer and the mask and obtaining a freestanding GaN bulk single crystal.

Such a method of preparing a GaN substrate is also known form EP-A-0810674. According to this method, the thickness of the epitaxial layers are between 70μm and 400μm.

Prior art ① and the GaN lateral growth are different in the starting substrate, the mask windows and the final etching. ① takes sapphire as a substrate, but the lateral GaN growth takes GaAs. ① maintains the sapphire substrate but the lateral GaN growth removes the GaAs substrate. ① uses a striped window mask but the lateral GaN growth uses either a mask having triangularly dotted windows or a mask having striped windows.

The striped window mask has an advantage of fast growth and a drawback of inviting distortion. The dotted window mask has a strong point of non-distortion and a weak point of slow growth. Here, the dotted window mask is explained. The whole surface of the mask is divided into equivalent equilateral triangles having a side parallel to a certain direction without blank. The mask is etched at the corners of the equilateral triangles for making windows. The shape of the window is arbitrary, e.g., round, square, ellipse, triangle or so. The side length (d) of the triangle is arbitrary, e.g., several micrometers. It is essential that the windows occupy the corners of equilateral triangles having a side parallel to a definite direction, which is here denoted by the y-direction.

The mask has many windows populating at the corners of the equilateral triangle imagined for covering the mask thoroughly. Since the dotted window mask is formed upon the GaAs wafer, the improved ELO deposits GaN films on the GaAs surface through the windows by a vapor phase epitaxy. The vapor phase epitaxial methods have some versions which will be explained later.

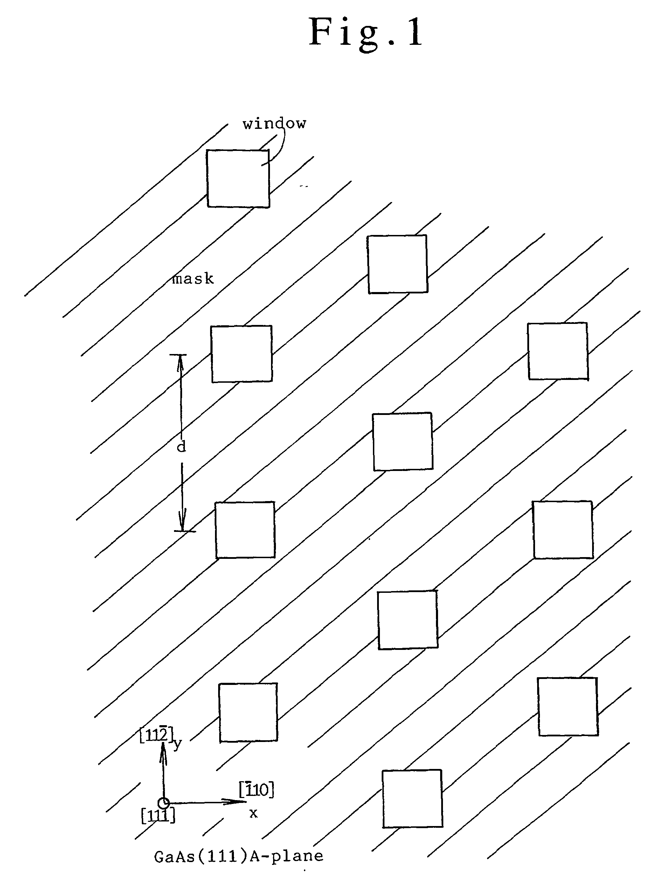

The GaN lateral growth method has been explained in detail by Japanese Patent Application No.9-298300 (298300/'97) and Japanese Patent Application No.10-9008(9008/'98) corresponding to EP-A-1041610. A GaAs (111) wafer is prepared. A mask is formed on the GaAs (111)A surface or the GaAs(111)B surface. Windows are made by etching the corner points of the equilateral triangles having a side in [11-2] direction. Fig. 1 shows the arrangement of the windows. The GaAs(111)A surface is a plane occupied only by Ga atoms. The GaAs(111)B surface is a plane occupied only by As atoms. Crystallography orders to annex an upper bar above a numeral for expressing a minus number. Here, the minus symbol is bluntly affixed in front of the numeral. Two axes which meet at right angles to the GaAs(111)A surface are [11-2] and [1-10]. Then, the coordinate is defined by y=[11-2] and x=[1-10] on the GaAs (111) surface. The length of a side of the equilateral triangle is denoted by "d". The aligning windows are divided into Group 1 and Group 2 in Fig. 1. The windows are defined by the coordinate (x,y) of the central point.

$$\text{Group 1} \quad x = 3^{1/2} kd, \qquad y = hd. \qquad (1)$$

$$\text{Group 2} \quad x=3^{1/2}(k+0.5)d, \qquad y=(h+0.5)d. \quad (2)$$

Here, k and h are integers. A window has six nearest neighbor windows. The unit vectors in the six directions are expressed by $(\pm 3^{1/2}/2, \pm 1/2)$ and $(0, \pm 1)$.

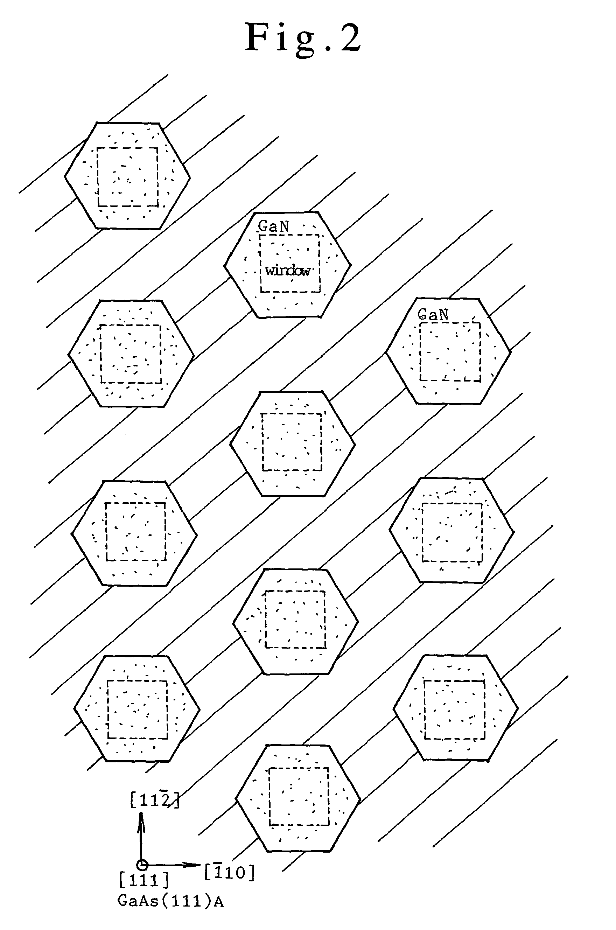

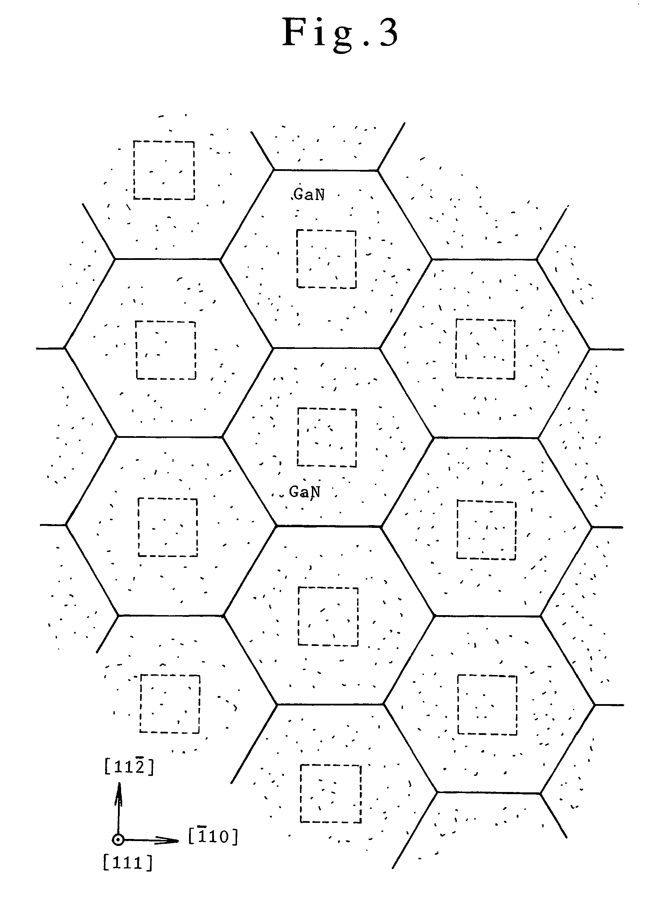

The windows are made by etching the corners of the equilateral triangles of the mask. GaN is grown on the revealed GaAs within the isolated windows. GaN nuclei appear on the isolated GaAs parts separated by the mask. The GaN nucleus has c-axis vertical to the GaAs(111) surface. The GaN[1-210] is parallel to GaAs[1-10]. The undercoat GaAs uniquely determines the orientations of the GaN nuclei. Thus, all the GaN nuclei have a common orientation. Since the mask has a function of impeding the growth of GaN, GaN does not grow on the mask at first. The GaN films enlarge and fill the windows. When tops of the GaN films attain to the upper surface of the mask, The GaN films overflow on the mask and begin to grow in the horizontal directions. A window has six nearest neighbor windows. The GaN films expand toward the six neighboring windows at a common speed. The outlines of the GaN films are hexagons, as shown in Fig.2. Since individual GaN films enlarge at a common speed, the GaN films come in contact with the nearest neighbors simultaneously, as shown in Fig.3. The simultaneous contact is important. The individual films are integrated into a GaN film. The integrated GaN film begins to grow again upward for increasing the thickness.

In other words, the windows are determined at the corners of equilateral triangles which cover the whole of the mask without blank. When a GaN nucleus enlarges in a hexagon within a window on the GaAs surface, a set of sides of the hexagon is vertical to the y-axis (GaAs[11-2]). Other sets of the sides incline at 30 degrees to the y-axis. In the term of GaAs crystal, the hexagon has a set of sides vertical to GaAs[11-2], another set of sides parallel to GaAs[2-1-1] and a further set of sides parallel to GaAs[-12-1]. Here, the expression is done by basing upon GaAs orientation.

The GaN crystal growing upon the GaAs substrate has different orientations from GaAs. GaAs belongs to the zinc blende type cubic symmetry group. Three parameters denote the orientations of GaAs. But GaN belongs to the hexagonal symmetry group which requires four parameters (klmn) for denoting the orientations. The three parameters k, l and m are not independent of each other, since the three parameters denote a orientation on c-plane. The parameters k, l and m are inverses of the segments cut by an object plane on three main axes (a,b,d) which meet at 120 degrees with each other. There is a sum rule of k+1+m=0. The final parameter n is an inverse of the segment cut by the object plane on c-axis. C-axis is vertical to a plane including a-, b- and d-axes. The hexagonal symmetry has six-fold rotation symmetry around c-axis. In the growth of GaN on GaAs, GaN c-axis is parallel to GaAs[111]. GaAs(111) plane has three-fold symmetry. GaN(0001) plane is parallel to GaAs(111)plane. GaN[10-10] is parallel to GaAs[11-2]. GaN[1-210] is parallel to GaAs[-110].

The Inventors have succeeded in making a wide, thick GaN single crystal by growing GaN films on a masked GaAs substrate and etching away the mask and the GaAs substrate.

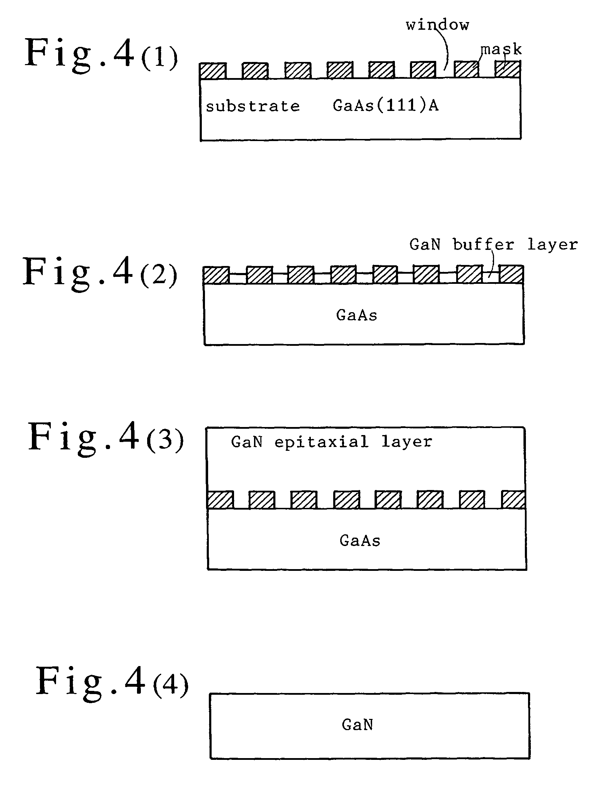

Fig.4(1), Fig.4(2), Fig.4(3) and Fig.4(4) show the steps of the epitaxial growth of GaN. Fig.4(1) shows a GaAs substrate and a window-perforated mask. Fig.4(2) shows the step of growing a GaN buffer film on the GaAs within the windows at a lower temperature. Fig.4(3) shows a thick epitaxial GaN film growing slowly on the buffer layer at a higher temperature covering the mask. Fig.4(4) shows an isolated GaN substrate by etching away the GaAs substrate and polishing away the mask. The buffer layer includes plenty of microcrystals due to the low temperature growth. The later epitaxial film is grown at a high temperature for reducing defects. The final GaN is a freestanding wafer. The GaN has a width and a thickness enough to the substrate for devices. There are still some problems for the freestanding GaN substrate crystal. For example, the thickness, the strength, the size and the distortion are still the problems.

However, the problem of the present invention is to control the conduction type of a GaN crystal. Prior GaN films have been made on a sapphire substrate mainly by an MOCVD method. Silicon (Si) is doped into the GaN for giving n-type conduction to the GaN crystal by the MOCVD. Silane gas ($SiH_4$) is the most accessible vapor compound including silicon (Si). The MOCVD supplies Si as an n-type dopant into the GaN film on a sapphire substrate. Silane gas is combustible, perilous gas which sometimes induces a sudden burst. Some safer n-dopant material than silane gas is desired for GaN. If the n-dopant has a high activation rate, the n-dopant is more desirable.

There is a hint on considering a new n-dopant. A non-doped GaN epitaxial film on sapphire reveals an n-type conduction property. A non-doped GaN film grown on a GaAs substrate by the lateral growth also reveals n-type conduction. Since Si is not doped, the n-dopant is not Si perhaps.

Why does the GaN show n-type conduction, though any n-dopant is not intentionally doped? What gives a non-doped GaN the n-type conduction? What is the cause of the n-type conduction in the non-doped GaN? What is the n-dopant? Vacancy? Hydrogen? Carbon?

A semiconductor is not necessarily intrinsic, even if an impurity is not intentionally doped. Even if an impurity is not doped, many semiconductors take either n-type or p-type. Non-doped Si is n-type. Non-doped GaAs is n-type. Non-doped GaN is n-type. Why can GaN be n-type despite non-doping?

SUMMARY OF THE INVENTION

It was the object of the present invention to clarify the n-type conduction of non-doped GaN single crystal. Another object of the present invention is to provide a method of doping an n-type impurity into a GaN single crystal substrate other than silicon. A further object of the present invention is to provide a method of making an n-type GaN bulk single crystal. A further object of the present invention is to provide an n-type single crystal GaN substrate.

The present invention achieves its object by providing a method of producing a gallium nitride single crystal substrate comprising the steps set out in claim 1.

What gives the n-type conduction to a non-doped GaN substrate is oxygen. The Inventors have discovered the fact that oxygen plays the role of an n-type impurity supplying conduction electrons to the GaN crystal.

Described in the Journal of Applied Physics, vol. 72, no. 2, 15 July 1992, pages 651-659, is an investigation on the influence of oxygen on the electrical and optical properties of GaN crystals grown by MOVPE. The presence of oxygen in the GaN layers changed the compensation behaviour of Zn.

Oxygen as n-dopant has advantages over Si, a well-known n-dopant. Doping of silicon requires silane gas ($SiH_4$) or the like. But silane gas is a dangerous gas. Oxygen doping to GaN is far safer than silicon doping. Even in the case of doping nothing, oxygen included in material gases remains in the synthesized GaN crystal. The remaining oxygen acts as an n-dopant in GaN. The Inventors have confirmed that the n-carrier (electron) density can be easily controlled by doping oxygen into a GaN crystal. According to the invention, the n-carrier concentration is in proportion to the oxygen concentration. The inventors propose a GaN single crystal substrate having n-carrier density between $1 \times 10^{16}$ cm$^{-3}$ and $1 \times 10^{20}$ cm$^{-3}$ based upon oxygen as an n-dopant. The n-carriers (electrons) are originated from oxygen as an n-dopant. Thus, the GaN substrate crystal of the present invention has an oxygen concentration ranging from $1 \times 10^{16}$ cm$^{-3}$ to $1 \times 10^{20}$ cm$^{-3}$. The Inventors found out that carbon disturbs the function of oxygen as an n-type dopant. Thus, the carbon concentration should be suppressed below $1 \times 10^{18}$ cm$^{-3}$ in the GaN crystal substrate of the invention. Preferably, the carbon concentration should be below $1 \times 10^{17}$ cm$^{-3}$. This invention requires dangerous silane gas no more, because the invention does not use silicon as an n-type dopant.

For example, a GaN film is epitaxially grown upon some substrate, e.g., sapphire by a HVPE (halide vapor phase epitaxy) method from materials of metal Ga, hydrochloric gas (HCl) and ammonia gas ($NH_3$). The GaN film exhibits n-type conduction which has electrons as major carriers. Since Si is not included in the film, Si is not the n-dopant in the GaN. Some element except Si should be the n-dopant in the GaN film on the substrate. The fact is that oxygen atoms included as an impurity in material gases give the n-type conduction to the GaN film by supplying electrons in the film.

In a GaN crystal, oxygen is an n-type dopant. Non-doped GaN reveals n-type conduction. The n-type conduction is caused by oxygen originally included in the material gases, $H_2$, HCl or $NH_3$. The fact requires far strict control of oxygen as an impurity in the material gases for determining the carrier concentration exactly. Inventor's experiments reveal the inclusion of greater amount of oxygen as an impurity in the material gases than the skilled man imagines. If oxygen exhibited no function in GaN, the oxygen inclusion could be ignored. In fact, the oxygen inclusion should not be ignored, since oxygen acts as an n-dopant of supplying n-carriers (electrons) in a GaN crystal. This invention selects oxygen as an n-type dopant for GaN crystals instead of Si which has been introduced by the dangerous gas, silane. Oxygen doping is still safer than Si doping. Another advantage of oxygen is a high activation rate which is nearly equal to 100%. The activation rate is defined as a quotient of the carrier number to the dopant number. Perhaps, oxygen atoms form shallow donor levels which easily give an electron to a GaN crystal.

Furthermore, oxygen exhibits a high activation rate in a wide range of concentration. Oxygen acts as an n-dopant with a high activation rate in a wide range of oxygen concentration between $1 \times 10^{16}$ cm$^{-3}$ and $1 \times 10^{20}$ cm$^{-3}$. The range of the oxygen concentration gives a carrier (electron) concentration ranging between $1 \times 10^{16}$ cm$^{-3}$ and $1 \times 10^{20}$ cm$^{-3}$, because the activation rate is nearly 100%.

Some method adopts metallorganic materials, e.g., trimethyl Ga(TMG) for Ga-including material gas. An MOCVD (metallorganic chemical vapor deposition) starts from metallorganic Ga. In this growing method, carbon atoms borne by the dissociation of metallorganic compounds remain in the crystal as an impurity. The Inventors found the fact that the residual carbon atoms in the GaN crystal induce instability of carriers. Sometimes carbon atoms act as donors making n-type carriers (electrons). Other times carbon atoms make deep trap levels which cancel other donors. The instability induced by the residual carbon is a nuisance for the exact control of carriers. The Inventors are aware of a decline of the intensity of photoluminescence in a GaN film at a high carbon concentration more than $1 \times 10^{18}$ cm$^{-3}$. The residual carbon atoms in the GaN should be suppressed to a small concentration of less than $1 \times 10^{18}$ cm$^{-3}$, preferably less than $10^{17}$ cm$^{-3}$ for allowing oxygen to act effectively as an n-dopant. The Inventors first noticed that the growth of a GaN film on a GaAs substrate enables us to control the carbon concentration in the GaN.

The advantage of the invention is explained. This invention clarifies that oxygen is an excellent n-dopant with an activation rate of nearly 100% in a GaN crystal for the first time. This invention adopts oxygen (O) as an n-dopant instead of silicon (Si). This invention allows exact control of the n-carrier concentration in a GaN crystal by adding O or $H_2O$ into material gases at a suitable ratio. Since the activation rate is nearly 100% in a wide range from $1 \times 10^{16}$ cm$^{-3}$

to $1 \times 10^{20}$ cm$^{-3}$ of oxygen concentration, this invention enables manufacturers to produce a GaN single freestanding crystal of an arbitrary carrier density between $1 \times 10^{16}$ cm$^{-3}$ to $1 \times 10^{20}$ cm$^{-3}$. The preferable range is $5 \times 10^{17}$ cm$^{-3}$ to $5 \times 10^{19}$ cm$^{-3}$ for both the oxygen concentration and the carrier concentration. The optimum concentration ranges from $1 \times 10^{18}$ cm$^{-3}$ to $1 \times 10^{19}$ cm$^{-3}$ both for oxygen and carriers. An increase of the carrier concentration raises the conductivity of the GaN. Low resistance is a favorable property as a substrate crystal. The upper limit is determined by the crystalline disorder caused by doping high density oxygen.

As mentioned at an early chance, GaN films have been piled epitaxially upon a sapphire substrate by the MOCVD method for fabricating blue light LEDs. The MOCVD uses silane gas (SiH$_4$) for doping Si as an n-dopant into a GaN film on the sapphire. Silane is a dangerous gas. This invention is immune from the danger by adopting safe oxygen gas as an n-dopant. This invention can produce an n-type GaN bulk single crystal by growing GaN films on a masked GaAs substrate and eliminating the GaAs and the mask. The bulk GaN crystal has n-type conduction due to the doped oxygen. When a blue light GaInN-LED is made upon the n-type GaN substrate, the bottom of the GaN substrate can be an n-electrode for directly bonded and connected to a stem. The LED device structure is simplified in comparison with the sapphire-based GaInN-LED. If a GaInN laser diode is fabricated on the n-GaN substrate, the blue light laser diode has a longer lifetime than the conventional sapphire-based blue light laser diode.

Examples of the invention will be described with reference to the several figures of the accompanying drawings in which:

Fig.1 is a partial plan view of a mask having windows and covering a GaAs (111)A plane of a GaAs (111) substrate.

Fig.2 is a partial plan view of the mask having windows and covering the GaAs substrate in a state in which epitaxially growing GaN films extend in hexagons over the windows of the mask.

Fig.3 is a partial plan view of the mask in a state in which epitaxially growing GaN films come in contact with each other in hexagons upon the mask.

Fig.4(1) is a sectional view of a GaAs (111) substrate and a mask having periodical windows and being formed on the GaAs substrate.

Fig.4(2) is a sectional view of the GaAs substrate, the mask and GaN buffer layers selectively deposited through the windows on the revealed GaAs substrate.

Fig.4(3) is a sectional view of the GaAs substrate, the mask and a GaN layer epitaxially growing far above the mask on the GaAs substrate.

Fig.4(4) is a sectional view of a GaN substrate obtained by eliminating the GaAs substrate and the mask.

Fig.5 is a schematic section of an HVPE apparatus for growing GaN films from H$_2$, metal Ga, HCl and NH$_3$.

Fig.6 is a graph showing the relation between oxygen concentration (cm$^{-3}$) and carrier concentration (cm$^{-3}$) in the GaN single crystal substrate made by the present invention.

GaN crystals can be produced on a substrate by the following four methods;

1. HVPE (Halide Vapor Phase Epitaxy) method
2. MOC (Metallorganic Chloride Vapor Phase Epitaxy) method
3. MOCVD (Metallorganic Chemical Vapor Phase Deposition) method
4. Sublimation method

The HVPE method selects metal gallium (Ga) as a Ga material. The HVPE once makes an intermediate compound (GaCl) by a reaction $2Ga + 2HCl \rightarrow 2GaCl + H_2$ and produces the object gallium nitride (GaN) from the gallium chloride (GaCl) and ammonia (NH$_3$) by another reaction $GaCl + NH_3 \rightarrow GaN + HCl + H_2$. This method is named "halide", since gallium chloride (GaCl), a halide, is once synthesized.

The MOC method chooses metallorganic gallium, e.g., trimethyl gallium (Ga(CH$_3$)$_3$), as a Ga material. The MOC produces an intermediate compound (GaCl) by a reaction $Ga(CH_3)_3 + HCl \rightarrow GaCl + \cdots$. The MOC makes GaN on a substrate from GaCl and NH$_3$ by another reaction $GaCl + NH_3 \rightarrow GaN + HCl + H_2$. The MOC is not a popular method. No other than the Applicant makes a GaN film epitaxially on a GaAs substrate at a temperature higher than 900°C by the MOC method.

The MOCVD method chooses metallorganic gallium as a Ga material like the MOC. The MOCVD is different from the HVPE and the MOC at the points of omitting the intermediate process. The MOCVD makes GaN at a stretch by reacting the metallorganic Ga with ammonia by a reaction $Ga(CH_3)_3 + NH_3 \rightarrow GaN + \cdots$. The MOCVD is a prevailing method. Almost all of the GaN epitaxial growths are done by the MOCVD method at present.

The sublimation method starts from polycrystal GaN. It makes a GaN single crystal film on a substrate by keeping the substrate at a lower temperature, heating the polycrystal material at a higher temperature for subliming the polycrystal into vapor and transporting the vapor to the substrate by the gradient of the temperature.

This invention turns out to be suitable for 1.HVPE method and 2.MOC method but unsuitable for the most prevalent 3.MOCVD method. This invention cannot be applied to the popular MOCVD method. Namely, the MOCVD method cannot realize this invention, because the MOCVD adopts metallorganic Ga and lacks the step of making the intermediate compound GaCl which has a function of eliminating carbon. As told before, carbon atoms sometimes act as an n-dopant or a p-dopant and other times act as a neutral impurity in a GaN crystal. The roles of carbon are ambiguous and unstable in GaN. When carbon is included in a GaN crystal, the n-carrier density is not in proportion to the oxygen concentration. The density of residual carbon should be suppressed at most less than $10^{18} cm^{-3}$ for allowing oxygen atoms to act as an n-dopant making shallow donor levels and for maintaining the proportional relation between the oxygen concentration and the electron concentration. Although the Inventors have not depicted exact image about the function of the residual carbon in a GaN crystal, the substantially non-carbon ($\leqq 10^{18} cm^{-3}$, preferably $\leqq 10^{17} cm^{-3}$) is the condition of the precise n-carrier control by oxygen. The MOCVD cannot prevent the carbon contained in trimethyl Ga from mixing into the GaN film. Slow growth allows the MOCVD to prevent carbon from mixing into GaN. Suppressing the carbon concentration below $1 \times 10^{18} cm^{-3}$ forces the MOCVD to grow a GaN film at a very low speed. The slow growth enhances the cost of the MOCVD. Thus, the prevalent MOCVD is inferior to the HVPE and the MOC.

This invention is suitable for the HVPE or the MOC producing GaN via the intermediate gallium chloride (GaCl). The intermediate GaCl vapor enables both the HVPE and the MOC to exclude carbon atoms completely or nearly completely from the GaN crystal by refining the material gases deliberately. The oxygen concentration is proportional to the free electron (n-carrier) concentration in the HVPE-made or MOC-made GaN crystal. Exact prescription of oxygen in the material gas is essential for controlling the n-carriers by the doping oxygen. For this reason, oxygen and water should be completely removed from material gases by repeated refinements till the oxygen density and the water density attain values below the detectable limits. After the complete refinement, a desired number of oxygen or water molecules are added to the material gases.

Oxygen gas or water is available for doping oxygen. Oxygen or water should be added to a congenial gas. Both the MOC and the HVPE use HCl gas, $H_2$, gas and $NH_3$ gas. The MOC further uses trimethyl Ga gas bubbled and carried by $H_2$. It is convenient to add oxygen or water to $H_2$ gas (carrier gas), HCl gas or $NH_3$ gas. Oxygen or water contained in HCl produces gallium oxide ($Ga_2O$) by reacting with the metal Ga or the metallorganic Ga. The $Ga_2O$ effectively is taken into the synthesized GaN film.

Other way of doping oxygen into a GaN crystal is an addition of oxygen or water into $NH_3$ gas which is supplied to the furnace in a diluted form of ($NH_3+H_2$) gas. It is convenient to add oxygen or water once to $H_2$ and to mix $NH_3$ with the $H_2$.

[EMBODIMENT 1: GaN/GaAs: HVPE method: three kinds of HCl gases]

A GaAs(111) wafer is prepared for a substrate crystal. A silicon dioxide ($SiO_2$) insulating film is formed uniformly upon the GaAs(111)A plane. Photolithography perforates a plenty of dottedly-populated square windows on the $SiO_2$ mask for revealing the undercoat GaAs surface partially within the windows, as shown in Fig. 1. Each window is a square of a 2 $\mu$m long side. A set of dotted windows align with a 4 $\mu$m long spatial period (d=4$\mu$m) in series in parallel with <11-2>-direction of the GaAs substrate. Being distanced by 3.5 $\mu$m(=3½ d/2) in vertical direction <-110>, a second set of windows align with a half period shift with the same period in series in the same direction as the former set. A third set of windows align with a half period shift with the same period in the same direction as the former sets. Similar alignments of windows are repeated on the mask. The centers of the nearest neighboring three windows form an equilateral triangle of a 4 $\mu$m long side in parallel with <11-2>. This step makes a masked GaAs wafer substrate.

A GaN buffer layer is piled till a thickness of 80nm at a comparatively low temperature of about 490 °C upon the masked GaAs substrate by the HVPE apparatus. Then, the wafer is further heated up to a temperature between 920°C and 1050°C. A GaN epitaxial layer is further piled on the buffer layer and the mask till a thickness of about 200 $\mu$m by the same HVPE apparatus.

The growing conditions and the thicknesses of the GaN buffer layer and the GaN epitaxial layer are as follows;

| (GaN buffer layer) | 490°C | 80nm |
| (GaN epitaxial layer) | 920°C~ 1050°C | 200 $\mu$m |

At an early stage, plenty of isolated GaN nuclei are borne upon the surface of the GaAs revealed within the windows of the mask. The orientation of the GaN nuclei is determined by the orientation of the undercoat GaAs crystal. GaN single crystal grains gradually grow from the GaN nuclei. The orientations of the grains are ruled by the undercoat GaAs. All the grains have the common orientation through the undercoat GaAs single crystal substrate. The GaN grains fill the windows of the mask. When the GaN grain crystals have filled the windows, the GaN crystals overflow upon the mask from the windows and develop on the mask in hexagons according to the crystal orientation of the undercoat GaAs, as shown in Fig.2. The overflowing GaN films also have the similar orientation to the undercoat GaAs. The isolated GaN films from the windows come into contact with the other films growing from the neighboring windows, as shown in Fig.3. Since all the isolated films are growing from their own windows at the same velocity in hexagons, the joints of the neighboring films form many hexagons like a honeycomb. The isolated films are integrated into a single film. Then the height of the integrated GaN film further increases in the HVPE apparatus.

Embodiment 1 chooses the HVPE (Halide Vapor Phase Epitaxy) method for making the GaN crystal. The HVPE method comprises the steps of preparing a quartz boat having metal Ga, storing the Ga-containing boat in the reaction furnace, heating the boat up to more than 800 °C , supplying hydrochloric gas (HCl) on the metal Ga in the furnace for synthesizing gallium chloride (GaCl), supplying ammonia gas $NH_3$ to the GaAs substrate wafer for making $NH_3$ react with the GaCl and growing GaN on the substrate. The carrier gas is hydrogen both for HCl and $NH_3$.

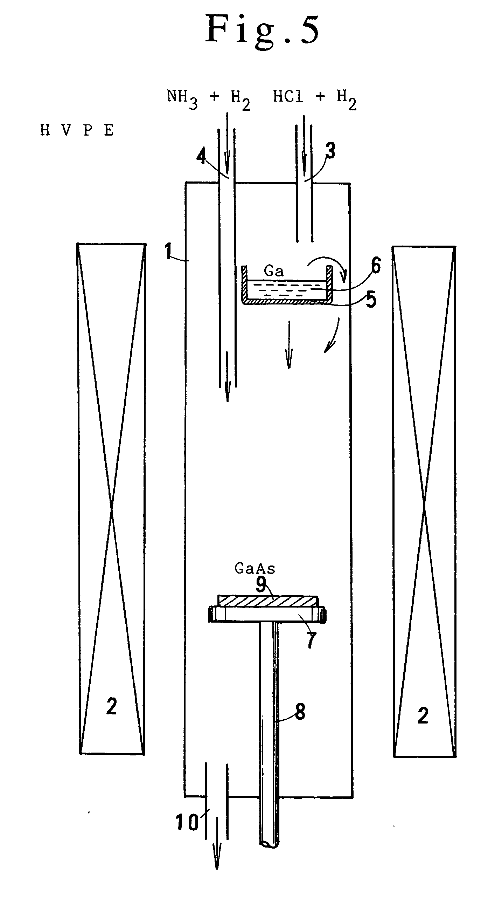

Fig.5 shows a section of the HVPE apparatus. The HVPE apparatus has a vertically elongating furnace 1. The vertical furnace 1 is equipped with a cylindrical heater 2. Shorter and longer material gas inlet tubes 3 and 4 are inserted at the top of the furnace 1. The shorter material gas inlet tube 3 introduces hydrochloric gas (HCl) and hydrogen gas ($H_2$). Hydrogen gas is a carrier gas for HCl. The longer material gas inlet tube 4 introduces ammonia gas ($NH_3$) and hydrogen gas ($H_2$). Hydrogen gas is a carrier gas for $NH_3$. The furnace 1 contains a Ga boat 5 just beneath the shorter material gas inlet tube 3. A Ga-melt 6 is filled in the Ga boat 5. A shaft 8 vertically pierces the bottom of the furnace 1. The shaft 8 can rotate and move up and down in the furnace 1. The shaft 8 holds a susceptor 7 on its top. A GaAs wafer 9 is put on the susceptor 7. The furnace 1 is provided with an exhaustion outlet 10 at the bottom for making the furnace vacuous. The exhaustion outlet 10 communicates with a vacuum pump (not shown in the figures). HCl gas and $H_2$ gas go into the furnace 1 from the gas inlet 3. $NH_3$ gas and $H_2$ gas are introduced to the furnace 1 from the gas inlet 4. HCl gas reacts with the Ga melt 6 for making gallium chloride (GaCl). The reaction is expressed by $2Ga + 2HCl \rightarrow 2GaCl + H_2$.

The HVPE method adopts metal Ga as the Ga-source. Metal Ga is a melt in the furnace. The HVPE (Halide vapor phase epitaxy) requires the material in vapor phase. The Ga melt is not vapor. Then, gallium chloride (GaCl) is once synthesized from the Ga melt and hydrochloric gas (HCl). GaCl takes vapor phase at a high temperature. Hydrogen gas can convey the GaCl gas from the Ga-boat to the object GaAs substrate. This method is called "halide" VPE, since it uses a "chloride" of Ga as Ga-material. Unlike the MOCVD, the HVPE does not use metallorganic compounds. The difference among the HVPE, MOC and MOCVD is the difference of the Ga-material. The N-material is ammonia ($NH_3$) which is common for the three methods.

Three kinds of gases (a), (b) and (c) are used as a material of HCl gas;

    (a) HCl gas containing about 2000 ppm water ($H_2O$) as an impurity,
    (b) HCl gas containing about 150 ppm water ($H_2O$) as an impurity,
    (c) high purity HCl gas purified many times.

As mentioned before, HCl gas, in general, includes oxygen and water as an impurity. Only repetitions of refinements exclude oxygen and water from HCl gas.

When the growth of the GaN film on the masked GaAs wafer finishes, the GaAs wafer is cooled. The GaAs wafer is taken out of the furnace. A continual mirror film of GaN coats the GaAs substrate. The substrate has a hybrid stratum structure of GaN/GaAs. Aqua regia can solve GaAs. The GaAs substrate is eliminated in aqua regia. GaN has resistance against aqua regia. Thus, only the GaN film remains. The GaN film has a thickness of about 200 $\mu$m. The GaN crystal film is freestanding due to the sufficient thickness. The freestanding GaN film is a single crystal. The single crystal GaN can be a GaN substrate for making GaN-like devices.

A plurality of GaN substrate crystals are produced by the method of the embodiment 1 by taking three kinds of HCl gases (a), (b) and (c) for investigating the relation between n-carrier (electron) concentration and oxygen concentration. The oxygen concentration and the n-carrier concentration in the sample GaN substrate crystals are measured. The oxygen concentration is measured by the SIMS (Secondary Ion-Mass Spectrography) which bombards the sample GaN substrate crystals with ions of inert gas, induces emission of secondary ions from the object GaN substrate crystals, counts the ions in divided ranges of energy, makes a spectrum of the secondary ions and calculates the ratios of the elements existing in the sample. The concentration of n-carriers (electrons) is determined by the Hall measurement.

The separated GaN substrate crystals reveal n-type conduction although Si is not doped into the GaN. Instead of Si, O acts as an n-type impurity for giving the n-type conduction to the GaN crystal. The electron (n-carrier) density is in proportion to the oxygen density. The carrier gas, hydrogen, contains oxygen or water. The nitrogen-source, ammonia, also contains oxygen or water. Then, the influence of water accompanies even the case of using purified HCl (c).

[EMBODIMENT 2: GaN/GaAs; HVPE method; $H_2O$ added HCl gas]

A GaN crystal is made on a GaAs substrate by a similar manner to embodiment 1. Namely, a GaN buffer layer and a GaN epitaxial layer are produced upon a masked GaAs wafer by a HVPE method supplying HCl+$H_2$ to a Ga melt for converting Ga to GaCl and supplying $NH_3 + H_2$ for making $NH_3$ react with GaCl, and making GaN on the GaAs substrate. Embodiment 2 differs from embodiment 1 at the HCl + $H_2$ gas which is supplied to the Ga-melt. Instead of HCl including water, hydrogen $H_2$ gas contains water. The prepared gases are;

(d) high purity HCl gas refined several times,
(e) humid hydrogen gas produced by bubbling ultrapure water with hydrogen gas.

A mixture of (d) and (e) at an arbitrary rate is supplied to the heated Ga-melt in the HVPE furnace. The rate $H_2O/HCl$ is continually varied in a range between 0 and 3000 ppm. Namely, $0 < H_2O/HCl \leqq 3000ppm$. In the first reaction of $2Ga + 2HCl \rightarrow 2GaCl + H_2$, since water ($H_2O$) included in $H_2$ gas, oxygen mixes into GaCl. An isolated GaN substrate is obtained by solving the GaAs substrate by aqua regia. The GaN substrate reveals n-type conduction despite of non-existence of Si. The carrier density is in proportion to the oxygen density. Embodiment 2 confirms that oxygen acts as an n-type impurity in GaN and water in $H_2$ is also effective for giving n-type conduction to GaN.

[EMBODIMENT 3; GaN/GaAs: HVPE method; $O_2$ added HCl gas]

Embodiment 3 makes a GaN single crystal film upon a masked GaAs substrate wafer in a similar way to embodiment 1. Like embodiment 1, a GaN buffer layer and a GaN epitaxial layer are grown by the HVPE method on a GaAs substrate by utilizing a mask having windows positioned at corners of equilateral triangles. The HCl gas is different from that of embodiment 1. Instead of water, oxygen is intentionally added to the HCl gas. Embodiment 3 introduces oxygen into the GaCl gas through the HCl gas. Prepared gases are;

(f) high purity HCl gas refined several times,
(g) high purity oxygen gas.

A mixture ($HCl+O_2$) of (f) and (g) at an arbitrary rate is supplied to the heated Ga-melt in the HVPE furnace. The rate $O_2/HCl$ is continually varied in a range between 0 and 3000 ppm. Namely, $0<O_2/HCl \leqq 3000ppm$. In the first reaction of $2Ga + 2HCl \rightarrow 2GaCl + H_2$ oxygen included in HCl mixes into GaCl gas. A freestanding GaN substrate crystal is obtained by solving the GaAs substrate and the mask by aqua regia. The produced GaN substrate reveals n-type conduction. The carrier density is in proportion to the oxygen density. Embodiment 3 confirms that oxygen acts as an n-type impurity in GaN and $O_2$ included in HCl gas is also effective for giving n-type conduction to GaN.

[EMBODIMENT 4; GaN/GaAs: HVPE method; $H_2O$ added $NH_3$ gas]

Embodiment 4 makes a GaN single crystal film upon a masked GaAs substrate wafer in a similar way to embodiment 1. Like embodiment 1, a GaN buffer layer and a GaN epitaxial layer are grown by the HVPE method on a GaAs substrate by utilizing a mask having windows positioned at corners of equilateral triangles. The $NH_3$ gas is different from that of embodiment 1. Instead of HCl, water is intentionally added to the $H_2$ carrier gas of $NH_3$. Thus, $NH_3$ gas substantially includes water ($H_2O$). Embodiment 4 introduces oxygen into the GaCl gas through the $NH_3$ gas. Prepared gases are;

(h) high purity $NH_3$ gas refined several times,
(i) humid hydrogen gas produced by bubbling ultrapure water with hydrogen gas .

A mixture ($NH_3+H_2$) of (h) and (i) at an arbitrary rate is supplied to react with GaCl in the HVPE furnace. It is not always necessary to guide all the carrier hydrogen gas into the bubbler. It is enough to make a part of hydrogen gas pass through the bubbler for making humid $NH_3$. The ratio of water in the humid ammonia gas is changed by controlling the temperature of the bubbler. The rate of $H_2O/(H_2+NH_3)$ is continually varied in a range between 5 ppm and 50 ppm. Namely, $5ppm \leqq H_2O/(H_2+NH_3) \leqq 50ppm$. Since the amount of supplied $NH_3$ gas is larger than HCl gas, the ratio of $H_2O/(H_2+NH_3)$ is smaller than the case of adding water to HCl gas. It is verified that oxygen is effectively included in the GaN crystal, even if the ratio of $H_2O/(H_2+NH_3)$ is small.

[EMBODIMENT 5; GaN/GaAs: HVPE method; $O_2$ added $NH_3$ gas]

Embodiment 5 makes a GaN single crystal film upon a masked GaAs substrate wafer in a similar way to embodiment 1. Like embodiment 1, a GaN buffer layer and a GaN epitaxial layer are grown by the HVPE method on a GaAs substrate by utilizing a mask having windows positioned at corners of equilateral triangles. The $NH_3$ gas is different from that of embodiment 1. Instead of HCl, oxygen ($O_2$) is intentionally added to $NH_3$. Two kinds of ammonia gases ($NH_3+H_2$) including 10ppm and 100ppm oxygen gas are used in embodiment 5. Namely, the rates are $O_2/(H_2+NH_3)$

=10ppm and 100ppm in the ammonia gas. Since the amount of supplied $NH_3$ gas is larger than HCl gas, the ratio of $O_2/(H_2+NH_3)$ is smaller than the case (embodiment 3) of adding oxygen to HCl gas.

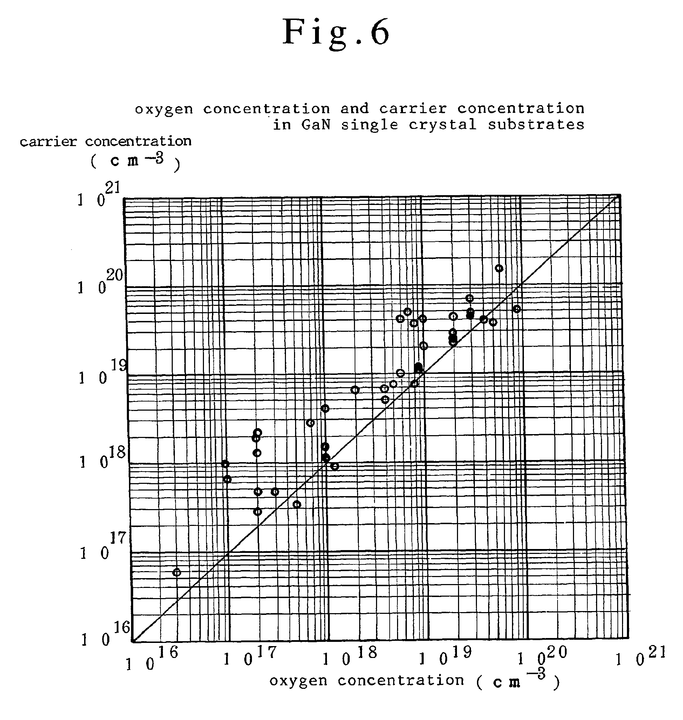

Fig.6 shows the result of measurements of oxygen concentration and n-carrier concentration in 38 samples of embodiments 1 to 5. The n-carrier is an electron. The abscissa is oxygen concentration (O) ($cm^{-3}$). The ordinate is carrier concentration (n) ($cm^{-3}$). The diagonal line is drawn for showing the relation of O=n, on which the carrier concentration is equal to the oxygen concentration. One sample corresponds to one dot. There are 38 dots in the graph. Two dots lie on the O=n diagonal line. Four dots lie below the O=n line. 32 dots distribute above the O=n line. The fact that the measurement dots lie nearly on the O=n line signifies that oxygen is the n-dopant in the GaN crystals of the 38 samples. O=n means that each of the oxygen donors gives an electron to the GaN crystal. O=n is the line of a 100% activation rate. 32 samples show an inequality of O < n. The fact that the carrier concentration is bigger than the oxygen concentration. The activation rate is more than 100% for oxygen. The Inventors cannot understand the reason of the activation rate over 100% yet. It may be caused by the difference between the object point (n) of the Hall measurement and the object point (O) of the SIMS.

Fig.6 confirms that the carrier concentration (n) is in proportion to the oxygen concentration (O) in the GaN samples of embodiments 1 to 5. It verifies the controllability of the carrier concentration by controlling the oxygen concentration. Fig.6 shows further that the equality of O=n is maintained in a very wide range of the oxygen concentration from $1 \times 10^{16}$ $cm^{-3}$ to $1 \times 10^{20}$ $cm^{-3}$. The wide range of equality means the excellency of oxygen as an n-dopant.

In general, carrier concentration is one of the objects which are frequently measured in semiconductor researches. The carrier density can be easily measured by the Hall measurement. The concentration of oxygen is not an object which is frequently measured. The oxygen measurement of the SIMS is not a facile measurement. Thus, nobody has noticed the possibility of oxygen donors before this invention. The repetitions of oxygen measurement by the SIMS taught us some facts. Even if a GaN crystal is made from the HCl gases (a) to (c) of embodiment 1 by the HVPE, the concentrations of the absorbed oxygen in the GaN are not a constant. Despite the use of the similar HCl gas, the oxygen concentrations in the GaN crystals fluctuate. It may be partly because other factors than HCl gas in embodiment 1 determine the ratio of the oxygen mixing in the GaN crystals. The oxygen concentration also depends upon the growing temperature (T) and the growing speed (v) of GaN.

The above measurements are done on the GaN crystal made by the HVPE method. A similar relation between oxygen and carrier of Fig.6 is also confirmed in the GaN crystals fabricated by the MOC(metallorganic chloride) method which makes GaCl by the reaction between $Ga(CH_3)_3$ and HCl and synthesizes GaN by the reaction between GaCl and $NH_3$. In both methods, carbon is excluded in the step of making the intermediate compound GaCl.

**Claims**

1. A method of producing a gallium nitride single crystal substrate comprising the steps of:

   preparing a GaAs (111) substrate, coating the GaAs substrate with a mask and etching the mask for making windows;
   carrying out refinements of the material gases HCl, $NH_3$ and $H_2$ till oxygen ($O_2$) and water ($H_2O$) are removed to attain values below detectable limits ;
   introducing the material gases HCl, $NH_3$ and $H_2$ in a reaction chamber for
   growing a GaN buffer layer on the masked GaAs substrate by a HVPE (Halide Vapor Phase Epitaxy) method or MOC (Metallorganic Chloride Vapor Phase Epitaxy) method comprising a first via-GaCl method which makes GaCl from a Ga material and HCl, and makes the GaCl react with $NH_3$ for producing GaN; and for
   growing a GaN epitaxial layer on said GaN buffer layer by a HVPE method or MOC method comprising a second via-GaCl method which makes GaCl from a Ga material and HCl, makes the GaCl react with $NH_3$ for producing GaN wherein in the step of growing an epitaxial layer after said refinement step, oxygen ($O_2$) or water ($H_2O$) is added at a suitable ratio to the material gases HCl, $NH_3$ and $H_2$ to be introduced to allow control of the n-carrier concentration in the GaN crystal;
   removing the GaAs substrate and the mask; and
   obtaining a freestanding n-type GaN single crystal substrate having oxygen as an n-dopant.

2. A method as claimed in claim 1, wherein the mask has dotted windows lying at points which correspond to corners of equilateral triangles having a side parallel with [11-2] direction of the GaAs substrate and covering the surface of the mask without gaps.

3. A method as claimed in claim 1, wherein the mask has parallel striped windows in parallel with either [11-2] direction or [1-10] direction of the GaAs substrate.

4. A method as claimed in claim 1, wherein the first via-GaCl method is an HVPE method which employs metal Ga, HCl, $H_2$ and $NH_3$ as materials, makes GaCl from metal Ga and HCl, and produces GaN by making the GaCl react with $NH_3$.

5. A method as claimed in claim 1, wherein the second via-GaCl method is an HVPE method which employs metal Ga, HCl, $H_2$ and $NH_3$ as materials, makes GaCl from metal Ga and HCl, and produces GaN by making the GaCl react with $NH_3$.

6. A method as claimed in claim 1, wherein the first via-GaCl method is an MOC method which employs metallorganic Ga, HCl, $H_2$ and $NH_3$ as materials, makes GaCl from metallorganic Ga and HCl, and produces GaN by making the GaCl react with $NH_3$.

7. A method as claimed in claim 1, wherein the second via-GaCl method is an MOC method which employs metallorganic Ga, HCl, $H_2$ and $NH_3$ as materials, makes GaCl from metallorganic Ga and HCl, and produces GaN by making the GaCl react with $NH_3$.

**Patentansprüche**

1. Verfahren zur Herstellung eines einkristallinen Galliumnitridsubstrats, das die Schritte umfasst:

Bereitstellen eines GaAs Substrats (111), Überziehen des GaAs Substrats mit einer Maske, und Ätzen der Maske zur Ausbildung von Öffnungen;
Ausführen von Verfeinerungen an den Materialgasen HCL, $NH_3$, und $H_2$ bis Sauerstoff ($O_2$) und Wasser ($H_2O$) entfernt sind, um Werte unterhalb detektierbarer Grenzen zu erzielen;
Einführen der Materialgase HCL, $NH_3$, und $H_2$ in eine Reaktionskammer zum
Wachsen einer GaN Pufferschicht auf dem maskierten GaAs Substrat mithilfe eines HVPE (Halogeniddampfphasenepitaxie) Verfahrens oder eines MOC (metallorganische Chloriddampfphasenepitaxie) Verfahrens, das ein erstes auf GaCl basierendes Verfahren umfasst, wobei in dem Verfahren GaCl aus einem Ga Material und HCL bildet wird, und das GaCl mit dem $NH_3$ reagiert, um GaN zu erzeugen; und zum
Wachsen einer GaN Epitaxieschicht auf der GaN Pufferschicht mithilfe eines HVPE Verfahrens oder eines MOC Verfahrens, das ein zweites auf GaCl basierendes Verfahren umfasst, wobei in dem Verfahren GaCl aus einem Ga Material und HCL bildet wird, und das GaCl mit dem $NH_3$ reagiert, um GaN zu erzeugen, wobei in dem Wachstumsschritt für die Epitaxieschicht nach dem Verfeinerungsschritt, Sauerstoff ($O_2$) oder Wasser ($H_2O$) in einem angemessenen Verhältnis zu den einzubringenden Materialgasen HCL, $NH_3$, und $H_2$ hinzugefügt wird, um eine Steuerung der n-Träger Konzentration in dem GaN Kristall zu gewährleisten;
Entfernen des GaAs Substrats und der Maske; und
Erzielen eines frei stehenden einkristallinen n-Typ GaN Substrats, das Sauerstoff als einen n-Dotierstoff aufweist.

2. Verfahren nach Anspruch 1, wobei die Maske punktförmige Öffnungen aufweist, die in Bereichen liegen, die den Ecken von gleichseitigen Dreiecken entsprechen, die eine Seite aufweisen, die parallel zu der [11-2] Richtung des GaAs Substrats verläuft, und die Fläche der Maske ohne Zwischenräume bedecken.

3. Verfahren nach Anspruch 1, wobei die Maske parallele streifenförmige Öffnungen aufweist, die entweder zu der [11-2] Richtung oder zu der [1-10] Richtung des GaAs Substrats parallel verlaufen.

4. Verfahren nach Anspruch 1, wobei das erste auf GaCl basierende Verfahren ein HVPE Verfahren ist, das Ga Metall, HCL, $H_2$ und $NH_3$ als Materialien verwendet, das GaCl aus Ga Metall und HCL bildet, und GaN erzeugt, indem das GaCl mit dem $NH_3$ reagiert.

5. Verfahren nach Anspruch 1, wobei das zweite auf GaCl basierende Verfahren ein HVPE Verfahren ist, das Ga Metall, HCL, $H_2$ und $NH_3$ als Materialien verwendet, das GaCl aus Ga Metall und HCL bildet, und GaN erzeugt, indem das GaCl mit dem $NH_3$ reagiert.

6. Verfahren nach Anspruch 1, wobei das erste auf GaCl basierende Verfahren ein MOC Verfahren ist, das metallorganisches Ga, HCL, $H_2$ und $NH_3$ als Materialien verwendet, das GaCl aus metallorganischem Ga und HCL bildet, und GaN erzeugt, indem das GaCl mit dem $NH_3$ reagiert.

**7.** Verfahren nach Anspruch 1, wobei das zweite auf GaCl basierende Verfahren ein MOC Verfahren ist, das metall-organisches Ga, HCL, $H_2$ und $NH_3$ als Materialien verwendet, das GaCl aus metallorganischem Ga und HCL bildet, und GaN erzeugt, indem das GaCl mit dem $NH_3$ reagiert.

**Revendications**

**1.** Procédé de fabrication d'un substrat monocristallin de nitrure de gallium comprenant les étapes consistant à :

préparer un substrat de GaAs (111), en recouvrant le substrat de GaAs avec un masque et en gravant le masque pour fabriquer des fenêtres ;
raffiner les gaz servant de matériaux HCl, $NH_3$ et $H_2$ jusqu'à ce que l'oxygène ($O_2$) et l'eau ($H_2O$) soient retirés pour atteindre des valeurs inférieures aux limites détectables ;
introduire les gaz servant de matériaux HCl, $NH_3$ et $H_2$ dans une chambre de réaction pour
assurer la croissance d'une couche tampon de GaN sur le substrat de GaAs masqué grâce à un procédé d'EPVH (épitaxie en phase vapeur aux halogénures) ou un procédé d'EPVCO (épitaxie en phase vapeur aux chlorures organométalliques) comprenant un premier procédé via-GaCl qui fabrique du GaCl à partir d'un matériau de Ga et de HCl et fait réagir le GaCl avec le $NH_3$ pour produire du GaN ; et pour
assurer la croissance d'une couche épitaxiale de GaN sur ladite couche tampon de GaN grâce à un procédé d'EPVH ou un procédé d'EPVCO comprenant un deuxième procédé via-GaCl qui fabrique du GACl à partir d'un matériau de Ga et de HCl, fait réagir le GACl avec le $NH_3$ pour produire du GaN, dans lequel, à l'étape consistant à assurer la croissance d'une couche épitaxiale, après ladite étape de raffinage, l'oxygène ($O_2$) ou l'eau ($H_2O$) est ajouté selon un rapport adéquat aux gaz servant de matériaux HCl, $NH_3$ et $H_2$ devant être introduits pour permettre le contrôle de la concentration en porteurs n dans le cristal de GaN ;
retirer le substrat de GaAs et le masque ; et
obtenir un substrat monocristallin de GaN de type n autoporté ayant de l'oxygène comme dopant n.

**2.** Procédé selon la revendication 1, dans lequel le masque a des fenêtres en pointillés se trouvant au niveau de points qui correspondent aux angles de triangles équilatéraux ayant un côté parallèle à la direction [11-2] du substrat de GaAs et couvrant la surface du masque sans interstices.

**3.** Procédé selon la revendication 1, dans lequel le masque a des fenêtres rayées parallèles qui sont parallèles à l'une ou l'autre des directions [11-2] et [1-10] du substrat de GaAs.

**4.** Procédé selon la revendication 1, dans lequel le premier procédé via-GaCl est un procédé d'EPVH qui utilise du Ga métallique, du HCl, du $H_2$ et du $NH_3$ comme matériaux, fabrique du GaCl à partir du Ga métallique et du HCl, et produit du GaN en faisant réagir le GaCl avec le NH3.

**5.** Procédé selon la revendication 1, dans lequel le deuxième procédé via-GaCl est un procédé d'EPVH qui utilise du Ga métallique, du HCl, du $H_2$ et du $NH_3$ comme matériaux, fabrique du GaCl à partir du Ga métallique et du HCl, et produit du GaN en faisant réagir le GaCl avec le $NH_3$.

**6.** Procédé selon la revendication 1, dans lequel le premier procédé via-GaCl est un procédé d'EPVCO qui utilise du Ga métallorganique, du HCl, du $H_2$ et du $NH_3$ comme matériaux, fabrique du GaCl à partir du Ga métallorganique et du HCl, et produit du GaN en faisant réagir le GaCl avec le $NH_3$.

**7.** Procédé selon la revendication 1, dans lequel le deuxième procédé via-GaCl est un procédé d'EPVCO qui utilise du Ga métallorganique, du HCl, du $H_2$ et du $NH_3$ comme matériaux, fabrique du GaCl à partir du Ga métallorganique et du HCl, et produit du GaN en faisant réagir le GaCl avec le $NH_3$.

# Fig.1

window

mask

d

$[11\bar{2}]\,y$

$[\bar{1}10]$

$[11\bar{1}]$

x

GaAs(111)A-plane

# Fig.2

GaN
window

GaN

$[11\bar{2}]$

$[111]$ → $[\bar{1}10]$

GaAs(111)A

# Fig.3

GaN

GaN

[11$\bar{2}$]

[$\bar{1}$10]

[111]

Fig.4(1)

window

mask

substrate    GaAs(111)A

Fig.4(2)

GaN buffer layer

GaAs

Fig.4(3)

GaN epitaxial layer

GaAs

Fig.4(4)

GaN

# Fig.5

H V P E

$NH_3 + H_2$   $HCl + H_2$

# Fig.6

oxygen concentration and carrier concentration
in GaN single crystal substrates